# EUROPEAN PATENT APPLICATION

(11) **EP 2 514 855 A1**
(43) Date of publication of application: **24.10.2012**
(21) Application number: 10837627.8
(22) Date of filing: 15.12.2010
(51) Int. Cl.: C23F 1/40

(54) **COMPOSITION FOR ETCHING RUTHENIUM-BASED METAL AND METHOD FOR PREPARING SAME**

(30) Priority: 17.12.2009 JP 2009286552
(71) Applicant: Showa Denko K.K., Tokyo 105-8518 (JP)
(72) Inventor: SATO, Fuyuki, Tokyo 105-8518 (JP); SAITO, Yasuo, Tokyo 105-8518 (JP)
(74) Representative: Strehl, Peter
(86) International application number: PCT/JP2010/072552
(87) International publication number: WO 2011/074601

(57) **Abstract**

A composition for etching of a ruthenium-based metal, in which there are added and mixed at least a bromine-containing compound, an oxidizing agent, a basic compound and water, wherein the amount of bromine-containing compound added is 2-25 mass%, as bromine, and the amount of oxidizing agent added is 0.1-12 mass%, with respect to the total mass, and the pH is at least 10 and less than 12. It is possible to accomplish efficient etching of ruthenium-based metals.

## Description

### Technical Field

The present invention relates to a composition for etching of a ruthenium-based metal, and to a process for preparation of the same. In particular, the invention relates to a composition suitable for use in etching of ruthenium metal and ruthenium alloys composed mainly of ruthenium, as well as a process for its preparation.

### Background Art

In recent years, the use of ruthenium is being investigated as a barrier metal for semiconductor devices. This is because ruthenium exhibits a barrier property, and also because when copper is used as the wiring metal, it exhibits satisfactory adhesiveness and maintains its conductivity even when oxidized. Ruthenium is also being noted as a capacitor electrode material for DRAM (Dynamic Random Access Memory), and as a material for stabilization of the magnetization direction in magnetic elements.

When ruthenium is formed as a film by sputtering, CVD or the like on a substrate such as a silicon wafer, the ruthenium also adheres onto the back side and edges of the substrate. If the ruthenium thin-film remaining on the back side and edges is left to remain, it may peel and become attached to the structural sections of the device at the substrate surface, or it may contaminate other substrates via the semiconductor device manufacturing apparatus, resulting in reduced product reliability or yields. For this reason, the back sides and edges of substrates must be cleaned either physically or chemically to remove the ruthenium.

The method of cleaning of a substrate having ruthenium accumulated on its back side or edges may be cleaning using an etching composition. However, ruthenium is a platinum-group element which is not easy to etch.

At the current time, the known etching compositions for ruthenium that are used in semiconductor device manufacturing steps include cerium salts and nitric acid (Patent document 1). However, cerium salts produce precipitates during etching, and the precipitates generated at the bottom of treatment tanks during manufacturing steps must be removed. In addition, the cerium salt-derived components remaining on the substrate surface after etching must be removed before its use in a semiconductor device, which is incompatible with contamination by metal ions. However, cerium salt-derived components are difficult to remove with purified water or ordinary acids, and they require re-cleaning with chemical agents such as hydrofluoric acid.

There have also been developed etching compositions using periodic acid or periodic acid salts (Patent document 2). However, because of the high cost of periodic acid and periodic acid salts, they are not suitable for use in large-scale manufacturing steps.

Tantalum is often also used as a barrier metal, for the purpose of improving the adhesion and barrier property of ruthenium on silicon substrate surfaces (Patent document 3). However, such etching compositions are also impractical because of the low etching rates for ruthenium alloy films containing tantalum. Tantalum is known to dissolve in acidic aqueous solutions containing hydrofluoric acid and in concentrated, strongly basic aqueous solutions of potassium hydroxide or the like at 30 mass% or greater, but they are difficult to use in combination with existing etching compositions for ruthenium because of precipitate formation, for example.

A method of etching ruthenium using sodium hypochlorite has also been disclosed (Patent document 4). When this method is applied for semiconductor devices, however, it introduces the problem of sodium ions as a contamination source, while the usable life of the solution is also inadequate.

Patent Document 5 discloses an etching composition using hydrobromic acid and an oxidizing agent (hydrogen peroxide or nitric acid). However, this etching composition is used for indium phosphide semiconductors, and is not disclosed as being effective for etching of ruthenium-based metals. Moreover, the etching composition is acidic and not basic.

Other etching methods for ruthenium that have been disclosed include an etching method for ruthenium films in which a ruthenium film formed on a substrate is etched with a chemical solution having a pH of 12 or greater and an oxidation-reduction potential of 300 mV vs. SHE or greater (Patent document 6), and a composition for etching of ruthenium comprising carboxylic acid and/or ammonia, hydrogen peroxide and water, the aqueous solution being acidic (with optional addition of acids including hydrobromic acid) (Patent document 7). However, these are intended for simple ruthenium metal, and are not described as being applicable for ruthenium alloy films.

### Prior Art Reference

### Patent Document

Patent document 1: Japanese Unexamined Patent Publication No. 2001-237389
Patent document 2: Japanese Unexamined Patent Publication No. 2006-148149
Patent document 3: Japanese Patent Public Inspection No. 2008-541428
Patent document 4: Japanese Unexamined Patent Publication No. 2001-240985
Patent document 5: Japanese Unexamined Patent Publication No. 2004-361434
Patent document 6: Japanese Unexamined Patent Publication No. 2002-161381
Patent document 7: Japanese Unexamined Patent Publication No. 2008-42014

### Disclosure of the Invention

### Problems to be Solved by the Invention

The present invention has been accomplished with the aim of solving the aforementioned problems, and its object is to provide an etching composition that allows efficient etching of films of ruthenium and ruthenium alloys composed mainly of ruthenium and including at least one other metal such as tantalum in a prescribed proportion (for the purpose of the invention, these will also be referred to collectively as "ruthenium-based metals"), as well as a process for preparation of the same.

### Means for Solving the Problems

As a result of diligent research on compositions for etching of films of ruthenium or ruthenium alloys composed mainly of ruthenium, the present inventors have completed this invention upon finding that a basic composition comprising a bromine-containing compound, an oxidizing agent, a basic compound and water added in prescribed amounts allows selective etching of ruthenium or ruthenium alloy films without damaging silicon-based substrates and thin-films of Si, Si₃N₄, SiO₂ or the like. Specifically, the invention relates to a composition for etching of a ruthenium-based metal which is a composition comprising prescribed amounts of a bromine-containing compound, an oxidizing agent, a basic compound and water, and which is basic, as well as a process for preparation of the same.

The invention comprises the following aspects, for example.
[1] A composition for etching of a ruthenium-based metal, in which there are added and mixed at least a bromine-containing compound, an oxidizing agent, a basic compound and water, wherein the amount of bromine-containing compound added is 2-25 mass%, as bromine, and the amount of oxidizing agent added is 0.1-12 mass%, with respect to the total mass, and the pH is at least 10 and less than 12.
[2] A composition for etching of a ruthenium alloy, in which there are added and mixed at least a bromine-containing compound, an oxidizing agent, a basic compound and water, wherein the amount of bromine-containing compound added is 2-25 mass%, as bromine, and the amount of oxidizing agent added is 0.1-12 mass%, with respect to the total mass, and the pH is at least 10 and not higher than 14.
[3] A composition for etching according to [1] or [2], wherein the bromine-containing compound is at least one selected from the group consisting of hydrogen bromide, sodium bromide, potassium bromide and tetramethylammonium bromide.
[4] A composition for etching according to any one of [1] to [3], wherein the oxidizing agent is hydrogen peroxide and/or nitric acid.
[5] A composition for etching according to any one of [1] to [4], which includes, as the basic compound, at least one selected from the group consisting of tetramethylammonium hydroxide, potassium hydroxide and sodium hydroxide.
[6] A composition for etching according to [1], wherein the pH is at least 10.5 and less than 12.
[7] A composition for etching according to [2], wherein the pH is at least 10.5 and not higher than 13.
[8] A composition for etching according to [1], wherein the ruthenium-based metal includes at least 70 atomic percent ruthenium.
[9] A composition for etching according to [1], wherein the ruthenium-based metal is ruthenium metal.
[10] A composition for etching according to [8], wherein the ruthenium-based metal includes at least 0.01 atomic percent and not greater than 30 atomic percent tantalum.
[11] A composition for etching according to [2], wherein the ruthenium alloy includes at least 70 atomic percent and not greater than 99.99 atomic percent ruthenium.
[12] A composition for etching according to [11], wherein the ruthenium alloy includes at least 0.01 atomic percent and not greater than 30 atomic percent tantalum.
[13] A process for preparation of a composition for etching according to any one of [1] to [12], which has a step of using hydrobromic acid as the bromine-containing compound and an aqueous hydrogen peroxide solution and/or nitric acid as the oxidizing agent, and preparing a mixed aqueous solution to which at least the hydrogen bromide and oxidizing agent have been added, and a step of adding a basic compound to the mixed aqueous solution, so that the hydrogen bromide concentration is 2-25 mass% as bromine and the oxidizing agent concentration is 0.1-12 mass%, and so that pH is a prescribed value.
[14] A method of treating a substrate, by etching of a ruthenium-based metal film and/or ruthenium alloy film accumulated on a substrate, using a composition for etching prepared by the process for preparation according to [13].

### Effect of the Invention

The composition for etching of the invention allows selective etching of a ruthenium film and/or ruthenium alloy film against a substrate material such as a semiconductor wafer, and it is therefore effective for cleaning of the back side and edges of a substrate such as a semiconductor wafer employing a ruthenium film and/or ruthenium alloy film. In addition, it may be widely used in steps for manufacturing of semiconductor elements, magnetic material elements, wirings, barrier metals, liner metals and electrodes that are formed on substrates such as semiconductor wafers, and for purposes including dissolution of ruthenium-based metals, such as in dissolving solutions to be used in pretreatment for analysis of elements present in ruthenium-based metals.

### Brief Description of the Drawings

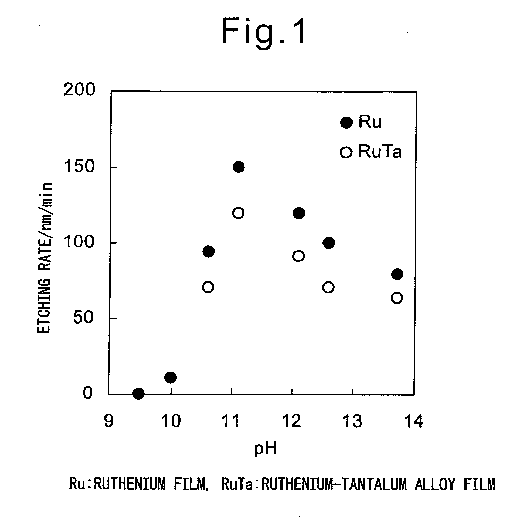

[Fig. 1] A graph showing etching rates for ruthenium films and ruthenium tantalum alloy films evaluated in the examples of the invention.

### Modes for Carrying Out the Invention

The present invention will now be explained in greater detail.

The composition for etching of the invention is a composition comprising a mixture of at least a bromine-containing compound, an oxidizing agent, a basic compound and water, and it is used under basic conditions with a pH of 10 or higher. The present inventors have found that a basic aqueous solution containing an oxide obtained by oxidation of a bromine-containing compound by an oxidizing agent under acidic conditions includes components (chemical species) with etching ability on ruthenium-based metals.

The bromine-containing compound to be used in the composition for etching of the invention is preferably at least one selected from the group consisting of hydrogen bromide, sodium bromide, potassium bromide and tetramethylammonium bromide. While the same effect can be obtained by directly oxidizing simple bromine as the bromine-containing compound, bromine has very strong corrosivity and toxicity, making it not easy to store and transport, and is more expensive than hydrogen bromide. Hypobromous acid also has etching ability, but it readily decomposes in acidic solutions, has insufficient stability in basic solutions as well, and is expensive. The bromine-containing compound may be added as an aqueous solution or as a solid during preparation of the composition for etching. Of the aforementioned bromine-containing compounds, it is preferred to use inexpensive hydrogen bromide. Hydrogen bromide can be added by bubbling hydrogen bromide gas into a liquid, but using hydrobromic acid as an aqueous solution is preferred for ease of handling. As bromine-containing compounds instead of hydrogen bromide there may be used bromides such as sodium bromide, potassium bromide and tetramethylammonium bromide. In this case, it is preferred to simultaneously add a strong acid in order to efficiently promote oxidation reaction. The strong acid is not particularly restricted so long as it has high acidity, and for example, hydrochloric acid, sulfuric acid, nitric acid or the like may be used, among which nitric acid is particularly preferred because it also has a function as an oxidizing agent (Examples 8-13 in Table 2). In order to improve the performance of the composition for etching, bromine, hypobromous acid, a hypobromous acid salt, bromous acid, a bromous acid salt, bromic acid or a bromic acid salt may also be added as necessary. These may be used alone or in combinations of two or more.

The bromine-containing compound is added to the etching composition at 2-25 mass%, more preferably 4-16 mass% and even more preferably 9-16 mass%, as bromine (Tables 1 and 2). If the addition concentration of the bromine-containing compound is lower than 2 mass% as bromine, the concentration of components (chemical species) that contribute to etching will be low, making it impossible to accomplish satisfactory etching. On the other hand, no significant improvement is seen in the etching rate if the addition concentration of the bromine-containing compound is higher than 25 mass% as bromine, and this is therefore economically disadvantageous.

The oxidizing agent to be used in the composition for etching of the invention is a compound having a function of oxidizing the bromine-containing compound and generating chemical species effective for etching of ruthenium metal, and specific examples include hydrogen peroxide, nitric acid, nitric acid salts, sulfuric acid, sulfuric acid salts, persulfuric acid, persulfuric acid salts, peroxodisulfuric acid, peroxodisulfuric acid salts, fluorine, chlorine, hypochlorous acid, hypochlorous acid salts, chlorous acid, chlorous acid salts, chloric acid, chloric acid salts, perchloric acid, perchloric acid salts, bromine, hypobromous acid, hypobromous acid salts, bromous acid, bromous acid salts, bromic acid, bromic acid salts, perbromic acid, perbromic acid salts, iodine, hypoiodous acid, hypoiodous acid salts, iodous acid, iodous acid salts, iodic acid, iodic acid salts, periodic acid, periodic acid salts, ruthenium tetraoxide, permanganic acid salts, ozone and cerium salts. These may be used alone or in combinations of two or more. The addition may be in the form of an aqueous solution or a solid. In order to increase the oxidizing power of the oxidizing agent, heating may be performed in a temperature range that does not cause boiling, during mixture with the bromine-containing compound. Preferred among the aforementioned oxidizing agents are hydrogen peroxide and nitric acid. When hydrobromic acid is used as the bromine-containing compound, hydrogen peroxide is preferred since it contains no metal ion and is readily available in the form of inexpensive high-purity products, and is capable of effectively oxidizing hydrobromic acid, and an aqueous hydrogen peroxide solution is preferably used from the viewpoint of ease of handling.

The addition concentration of the oxidizing agent that is suitable will differ depending on its type, but for most purposes it is added at 0.1-12 mass% of the etching composition, and in the case of hydrogen peroxide it is added at preferably 0.5-10 mass% and more preferably 2.5-10 mass% (Table 1), while in the case of nitric acid it is added at preferably 4-10 mass% and more preferably 4-5 mass% (Table 2). If the addition concentration of the oxidizing agent is lower than 0.1 mass% it will not be possible to completely oxidize the bromine-containing compound and the etching rate will be extremely low, which is impractical. If the addition concentration of the oxidizing agent is greater than 12 mass%, it will not be possible to suitably generate components that contribute to etching of ruthenium-based metals, and the etching rate will be reduced.

A basic compound is used in the composition for etching of the invention to adjust the pH of the composition for etching to basicity, and the addition amount may be modified as desired for adjustment of the pH so that the desired etching rate is obtained. The pH of the composition for etching of a ruthenium-based metal according to the invention is at least 10 and less than 12, and more preferably it is at least 10.5 and less than 12. Also, the pH of the composition for etching of a ruthenium alloy according to the invention is at least 10 and not higher than 14, and more preferably at least 10.5 and not higher than 13. If the pH of the composition for etching is less than 10, the etching rate for ruthenium-based metals will be extremely small, at less than 10 nm/min, which is impractical. The composition for etching of the invention has a pH value within the aforementioned pH range under the temperature of use (etching). That is, when the etching composition is to be used with heating to a temperature above room temperature, such as 50°C, the pH at 50°C is within the aforementioned range. The pH values for a composition for etching of the invention that has been prepared to room temperature (25°C) will be roughly the same at room temperature (25°C) and at 50°C, and the pH may vary during use. During the etching treatment, the composition for etching of the invention is used in the aforementioned pH range at the etching temperature.

According to the invention, "ruthenium-based metal" refers to a metal containing at least 70 atomic percent ruthenium, and also includes ruthenium oxides (RuOₓ), nitrides (RuN) and oxynitrides (RuNO). That is, the term includes ruthenium metal alone, alloys containing at least 70 atomic percent ruthenium, and ruthenium oxides (RuOₓ), nitrides (RuN) and oxynitrides (RuNO). According to the invention, "ruthenium alloy" refers to an alloy containing at least 70 atomic percent ruthenium, and metals other than ruthenium at higher concentrations than unavoidable concentrations. That is, the term "ruthenium alloy" according to the invention includes products with a lower ruthenium content than the purity of products that are commercially available as ruthenium metal. Thus, the upper limit for ruthenium in a "ruthenium alloy" according to the invention is 99.99 atomic percent.

There are no particular restrictions on the basic compound to be used in the composition for etching of the invention, and tetramethylammonium hydroxide, potassium hydroxide, sodium hydroxide, ammonia, calcium hydroxide, barium hydroxide, magnesium hydroxide, tetraethylammonium hydroxide, trimethylamine, triethylamine, piperidine, piperazine, N-methylmorpholine, choline, imidazole, imidazolium derivatives, pyridine, pyridinium derivatives, pyrrole, pyrrolidium derivatives, guanidine and the like may be used. These may be used alone or in combinations. Among these, sodium hydroxide and potassium hydroxide are preferred because they give high etching rates and are easy to obtain. Tetramethylammonium hydroxide is suitable for semiconductor devices because it contains no metal ions, and is more preferred for a high etching rate. The basic compound may be added as an aqueous solution or a solid during preparation of the composition for etching.

The composition for etching of the invention is intended to be a composition in which a bromine-containing compound, an oxidizing agent, a basic compound and water are added and mixed, and the prescribed bromine-containing compound and oxidizing agent contents and pH are as prescribed, but a composition in which these components have mixed and reacted, and the actual concentrations of the bromine-containing compound and oxidizing agent in the composition deviate from the prescribed addition amounts, are also encompassed within the scope of the invention. The reaction products may be primarily bromine, hypobromous acid, hypobromite ion, bromous acid, bromite ion, bromic acid, bromate ion and bromide ion.

The procedure for preparing an etching composition of the invention is preferably carried out by adding a bromine-containing compound to an oxidizing agent, and adding a basic compound to the mixture to appropriately adjust the pH. More specifically, for an example of using hydrobromic acid as the bromine-containing compound, first an aqueous solution of hydrobromic acid and an aqueous solution of an oxidizing agent are mixed in consideration of the hydrogen bromide and oxidizing agent concentrations in each aqueous solution to obtain the desired mixing ratio, and then the basic compound is added to reach the desired pH while measuring the pH of the mixture. The preparation may be accomplished by another method, so long as the performance as a composition for etching is satisfied.

The etching composition of the invention will usually be used as an aqueous solution, but if necessary an organic solvent that is compatible with water, such as acetonitrile, acetone, methanol or ethanol, may also be added.

If necessary, a surfactant such as an alkyltrimethylammonium bromide, sodium alkylsulfate or polyethyleneglycol mono-4-alkylphenyl ether may be added to the etching composition of the invention for the purpose of preventing deposition of the additives in the composition or inhibiting adhesion of etching scum onto the substrate surface. There is no limitation to these, so long as the etching performance is not affected.

To the etching composition of the invention there may also be added organic acids, inorganic acids or chelating agents, including EDTA (ethylenediaminetetraacetic acid), thiourea, urea, acetylacetone, catechol, pyrogallol, hydroquinone, resorcinol, citric acid, formic acid, ascorbic acid, oxalic acid, acetic acid, tartaric acid, succinic acid, succinic acid imide, malonic acid, malic acid, maleic acid, glutaric acid, adipic acid, D-glucanic acid, itaconic acid, citraconic acid, mesaconic acid, 2-oxoglutaric acid, trimellitic acid, endothall, glutamic acid, methylsuccinic acid, citramalic acid, ethylenediamine, o-phenanthroline, 2,2'-bipyridine, 4,4'-bipyridine, pyrazine, cyanic acid, thiocyanic acid, 1-hydroxyethylidene-1,1-diphosphonic acid, creatine, creatinine, cyanuric acid, sulfamic acid, melamine, hydantoin, biuret, monoethanolamine, diethanolamine and their derivatives, within ranges that do not interfere with the etching performance of the etching composition of the invention, for the purpose of capturing ruthenium ion produced by dissolution of the ruthenium-based metal by the composition for etching of the invention, or preventing decomposition of the oxidizing agent. These additives may also be added in the form of salts. There is no limitation to addition of these, so long as the etching performance is not affected.

For stabilization of the usable life of the solution, hydrochloric acid or a chloride may be added as well. Examples of chlorides include sodium chloride, potassium chloride, ammonium chloride and tetramethylammonium chloride.

There are no particular restrictions on the method in which the ruthenium or ruthenium alloy film, which is to be treated using a composition for etching of the invention, is formed on the substrate, and any method such as CVD (Chemical Vapor Deposition), ALD (Atomic Layer Deposition), sputtering or vacuum vapor deposition may be employed, also with no limitations on the film-forming conditions.

Tantalum may be mentioned as a typical example of another metal to be included in a ruthenium alloy that is composed mainly of ruthenium, according to the invention. If the tantalum content in the ruthenium-based metal or ruthenium alloy is not greater than 20 atomic percent, it will be possible to accomplish etching with the etching composition of the invention, albeit with a slight difference in etching rate. With an even larger content, the etching rate will be reduced somewhat, but etching will be possible. Metals other than tantalum that may be present in the ruthenium alloy include Si, Cu, Hf, Zr, Al, V, Co, Ni, Mn, Au, Rh, Pd, Ti, W and Mo, and their oxides, nitrides and silicides may also be present. A practical etching rate can be obtained if their total amount in the ruthenium alloy film is in a range not exceeding 30 atomic percent.

The composition for etching of the invention allows selective etching of ruthenium-based metal films without causing damage to substrate materials composed mainly of silicon, such as Si, SiO₂, SiC and Si₃N₄.

By altering the amounts of the bromine-containing compound, oxidizing agent and basic compound added to the composition for etching of the invention, it is possible to adjust the pH of the composition for etching, the etching rate, and the usable life of the solution.

By adding a component with pH buffer action to the composition for etching of the invention, it is possible to accomplish etching with a stable pH. The pH buffering component may be any one that stabilizes the pH under basic conditions, such as phosphoric acid, polyphosphoric acid, boric acid, citric acid, phthalic acid, acetic acid, carbonic acid, or salts thereof. There is no limitation to these, so long as the etching performance is not affected.

The composition for etching of the invention may also be heated for use. By conducting etching treatment at preferably 15-60°C, it is possible to obtain an excellent etching rate and usable life of the solution. It is preferably not used at a temperature lower than 15°C because the etching rate may be reduced, and it is preferably not used at a temperature higher than 60°C because volatilization and decomposition of the etching composition components may be accelerated and the usable life of the solution may be shortened. The composition for etching of the invention has a pH value within the aforementioned pH range under the temperature of use (during etching), as mentioned above.

If the bromine-containing compound, oxidizing agent, basic compound and additives in the composition for etching of the invention are selected so as to contain no metal components, it will be possible to accomplish etching treatment without contamination of the semiconductor device with metals. On the other hand, when a metal component-containing composition is used, it may be used for electronic devices for which contamination by metals is not a concern, such as MEMS devices, while for electronic devices that are concerned for contamination with metals, it may be used after etching treatment with a treatment solution of the invention followed by cleaning treatment with dilute hydrochloric acid or the like.

There are no particular restrictions on electronic devices employing the ruthenium-based metal film, and there may be mentioned display devices, semiconductor devices, MEMS devices and printed wiring boards. These also include those wherein, even if a ruthenium or ruthenium-based metal film does not remain on the final product, a ruthenium-based metal film is used during the production process and the ruthenium-based metal film is to be entirely removed by dissolution with the composition for etching.

Treatment of a substrate such as a silicon wafer by a composition for etching of a ruthenium-based metal according to the invention will usually be carried out by supplying the composition for etching to the back side and edges of the substrate using a sheet-fed method. The treatment may also be carried out by another method, such as a batch method, for example. Such treatment may be carried out while stirring or rocking, or applying ultrasonic waves. It may also be used not only on the back side and edge faces, but also for formation of the semiconductor elements, magnetic material elements, wirings, barrier metals, liner metals and electrodes to be formed on the substrate.

The composition for etching of a ruthenium-based metal of the invention may be employed as a dissolving solution, to be used in pretreatment for analysis of various elements other than ruthenium metals in a metal film. For example, a metal thin-film containing ruthenium may be dissolved with a composition for etching of the invention and, in combination with other pretreatment, provided as a sample for measurement by ICP emission spectroscopy, ICP mass spectrometry or absorption spectrophotometry.

### Examples

The present invention will now be explained in greater detail by examples, with the understanding that the invention is not limited only to these examples.

A ruthenium film, or an alloy film containing 20 atomic percent tantalum in addition to ruthenium, was formed by sputtering on a 1 mm-thick silicon wafer. The film thickness in each case was 50 nm. Each substrate was cut into a 3 mm square to obtain a sample piece for measurement of the etching rate.

For Si and SiO₂, Si was evaluated using the silicon wafer directly, and SiO₂ was evaluated using a SiO₂ film formed by sputtering to a film thickness of 50 nm on the silicon wafer. Each substrate was cut to a length of 15 mm and a width of 5 mm to obtain a sample piece for measurement of the etching rate. For Si₃N₄, a film was formed in the same manner by sputtering on the 1 mm-thick silicon wafer, to obtain a sample piece.

### Example 1

After placing 1 mL of a 35 mass% aqueous hydrogen peroxide solution (product of Kishida Chemical Co., Ltd.) in a glass container, 4 mL of 48 mass% hydrobromic acid (product of Wako Pure Chemical Industries, Ltd.) was slowly dropped into it while cooling with a water bath at ordinary temperature, and the container was covered in a non-airtight manner and allowed to stand for 3 hours. Next, a 9 mL 35 mass% aqueous tetramethylammonium hydroxide solution (product of SAChem, prepared with dilution of pentahydrate with purified water) was added, and a trace amount of a 35 mass% aqueous tetramethylammonium hydroxide solution was further added to pH 11, to obtain a composition for etching having the composition listed in Table 1. The liquid temperature of the composition for etching at this time was 25°C. The remainder after the components listed in Table 1 was purified water (ion-exchanged water). An F-52 pH meter by Horiba, Ltd. (using pH electrodes (9611-10D)) was used for adjustment and measurement of the pH.

Next, 0.5 mL of the prepared composition for etching was loaded into a polyethylene sample tube, and a thermostatic bath was used for warming to 50°C. The pH of the composition for etching was 10.9 at 50°C. The ruthenium or ruthenium tantalum alloy film-attached sample piece was loaded therein and allowed to stand, the time until disappearance of the metal film was visually observed and measured, and the etching rate was calculated. Measurement was conducted at least 2 times for calculation, and the average value was used. The results are shown in Table 1. Upon completion of etching, the pH of the composition for etching was 10.7 at 50°C.

Samples for measurement of the Si, SiO₂ and Si₃N₄ etching rates were also etched with the composition for etching. For the etching, 0.2 mL of the composition for etching was loaded into a polyethylene sample tube, a thermostatic bath was used for warming to 50°C, and the sample piece was loaded in and allowed to stand for 50 minutes. The sample piece was placed with a portion thereof exposed out of the composition for etching, the thickness difference between the portion immersed in the etching composition and the portion not immersed was measured with a surface roughness meter, and the etching rate was calculated. Measurement was conducted at least 2 times for calculation, and the average value was used. The results are summarized in Table 1.

### Examples 2-13, Comparative Examples 1-6

Compositions for etching were prepared in the same manner as Example 1 having the compositions listed in Tables 1 and 2, and the etching rates for ruthenium, ruthenium tantalum alloy, Si, SiO₂ and Si₃N₄ were measured at the temperatures listed in Tables 1 and 2. The results are shown in Tables 1 and 2. For preparation of the compositions for etching in Examples 8 to 13 and Comparative Examples 5 and 6 there was used 97 mass% fuming nitric acid (product of Wako Pure Chemical Industries, Ltd.), for preparation of the composition for etching in Example 7 there was used a 50 mass% potassium hydroxide solution (product of Kishida Chemical Co., Ltd., commercially available solid dissolved with purified water), and for preparation of the composition for etching in Example 13 there was used a 40 mass% aqueous sodium bromide solution (product of Wako Pure Chemical Industries, Ltd., commercially available solid dissolved with purified water). Also, for preparation of the compositions for etching in Comparative Examples 3 and 4, there were used 35 mass% hydrochloric acid (product of Wako Pure Chemical Industries, Ltd.) and 56 mass% hydroiodic acid (product of Wako Pure Chemical Industries, Ltd.).

[Table 1]

**Table 1**

| | Composition and addition amount (mass%) | | | Bromine content (mass%) | pH | Temp. (°C) | Etching rate (nm/min) | | | | |
|---|---|---|---|---|---|---|---|---|---|---|---|
| | | | | | | | Ru | RuTa | Si | Si₃N₄ | SiO₂ |
| Example 1 | HBr (14) | H₂O₂ (2.5) | TMAH (23) | 14 | 11 | 50 | 113 | 72 | <1 | <1 | <1 |
| Example 2 | HBr (22) | H₂O₂ (3.9) | TMAH (22) | 22 | 11 | 50 | 75 | 58 | <1 | <1 | <1 |
| Example 3 | HBr (3) | H₂O₂ (0.5) | TMAH (5) | 3 | 11 | 50 | 20 | 18 | <1 | <1 | <1 |
| Example 4 | HBr (14) | H₂O₂ (0.1) | TMAH (25) | 14 | 11 | 50 | 14 | 13 | <1 | <1 | <1 |
| Example 5 | HBr (13) | H₂O₂ (9.2) | TMAH (17) | 13 | 11 | 50 | 125 | 85 | <1 | <1 | <1 |
| Example 6 | HBr (14) | H₂O₂ (2.6) | TMAH (22) | 14 | 11 | 25 | 100 | 43 | <1 | <1 | <1 |
| Example 7 | HBr (23) | H₂O₂ (4.2) | KOH (20) | 23 | 11 | 50 | 120 | 59 | <1 | <1 | <1 |
| Comp. Ex. 1 | HBr (21) | H₂O₂ (3.9) | TMAH (16) | 21 | 8 | 50 | <1 | <1 | <1 | <1 | <1 |
| Comp. Ex. 2 | HBr (21) | H₂O₂ (3.9) | - | 21 | <1 | 50 | <1 | <1 | <1 | <1 | <1 |
| Comp. Ex. 3 | HCl (12) | H₂O₂ (1.5) | TMAH (21) | 0 | 11 | 50 | <1 | <1 | <1 | <1 | <1 |
| Comp. Ex. 4^{*} | Hl (12) | H₂O₂ (1.9) | TMAH (7.8) | 0 | 11 | 50 | <1 | <1 | <1 | <1 | <1 |

| | | | | | | | | | | | |
|---|---|---|---|---|---|---|---|---|---|---|---|
| TMAH: Tetramethylammonium hydroxide *Precipitation | | | | | | | | | | | |

[Table 2]

**Table 2**

| | Composition and addition amount (mass%) | | | Bromine content (mass%) | pH | Temp. (°C) | Etching rate (nm/min) | | | | |
|---|---|---|---|---|---|---|---|---|---|---|---|
| | | | | | | | Ru | RuTa | Si | Si₃N₄ | SiO₂ |
| Example 8 | HBr (9.6) | HNO₃ (4.9) | TMAH (19) | 9.5 | 11 | 50 | 117 | 68 | <1 | <1 | <1 |
| Example 9 | HBr (16) | HNO₃ (4.0) | TMAH (22) | 16 | 11 | 50 | 111 | 66 | <1 | <1 | <1 |
| Example 10 | HBr (14) | HNO₃ (9.7) | TMAH (21) | 14 | 11 | 50 | 50 | 36 | <1 | <1 | <1 |
| Example 11 | HBr (4.4) | HNO₃ (8.8) | TMAH (20) | 4.3 | 11 | 50 | 47 | 35 | <1 | <1 | <1 |
| Example 12 | HBr (3.2) | HNO₃ (1.6) | TMAH (6.3) | 3.2 | 11 | 50 | 19 | 10 | <1 | <1 | <1 |
| Example 13 | NaBr (18) | HNO₃ (11) | TMAH (16) | 14 | 11 | 50 | 94 | 23 | <1 | <1 | <1 |
| Comp. Ex. 5 | HBr (6.9) | HNO₃ (14) | TMAH (25) | 6.8 | 11 | 50 | <1 | <1 | <1 | <1 | <1 |
| Comp. Ex. 6 | HBr (11) | HNO₃ (11) | - | 11 | <1 | 25 | <1 | <1 | <1 | <1 | <1 |

### Example 14

Compositions for etching with different pH values, containing 14 mass% hydrogen bromide and 5% hydrogen peroxide, were prepared by the same procedure as in Example 1, and the etching rates for a ruthenium film and a ruthenium tantalum alloy film were measured at 50°C. The results are shown in Fig. 1.

As shown by Examples 1 and 5 in Table 1 and Examples 8 and 9 in Table 2, high etching rates of 100 nm/min or greater were obtained with the compositions for etching of the invention. The etching rate tended to be maximum at near pH 11 when using both hydrogen peroxide (Table 1) and nitric acid (Table 2) as the oxidizing agent. Similar results were obtained for Example 6 in Table 1, where the evaluation was conducted at ordinary temperature (25°C), and for Example 7 in Table 1 which employed potassium hydroxide as the basic compound. From the viewpoint of productivity, an etching rate of at least about 10 nm/min is generally preferred for removal of ruthenium films accumulated on the back sides and edges of semiconductor devices, and the composition for etching of the invention satisfies this condition. Where treatment is possible at ordinary temperature, it is preferred because it allows the cleaning apparatus for substrates to be more simply, and results in more moderate decomposition and volatilization of the composition for etching.

Etching of ruthenium and ruthenium tantalum alloy could not be accomplished in a pH range of lower than 9, as shown by Comparative Example 1 in Table 1. As shown by Comparative Examples 3 and 4 in Table 1, using hydrochloric acid or hydroiodic acid instead of hydrobromic acid did not allow etching of ruthenium or ruthenium tantalum alloy to be accomplished.

Since the composition for etching of the invention does not etch silicon-based materials (Si, Si₃N₄, SiO₂), it allows selective etching of ruthenium-based metals to be performed on such materials.

As shown in Fig. 1, it is possible to accomplish etching of ruthenium-based metals at pH 10 and higher. The etching rate also varied with the pH, and a high etching rate for ruthenium-based metals was obtained near pH 11 with the composition for etching of the invention.

### Industrial Applicability

The present invention is industrially useful since it provides a composition for etching capable of efficient etching of ruthenium-based metals.

## Claims

1. A composition for etching of a ruthenium-based metal, in which there are added and mixed at least a bromine-containing compound, an oxidizing agent, a basic compound and water, wherein the amount of bromine-containing compound added is 2-25 mass%, as bromine, and the amount of oxidizing agent added is 0.1-12 mass%, with respect to the total mass, and the pH is at least 10 and less than 12.

2. A composition for etching of a ruthenium alloy, in which there are added and mixed at least a bromine-containing compound, an oxidizing agent, a basic compound and water, wherein the amount of bromine-containing compound added is 2-25 mass%, as bromine, and the amount of oxidizing agent added is 0.1-12 mass%, with respect to the total mass, and the pH is at least 10 and not higher than 14.

3. A composition for etching according to claim 1 or 2, wherein the bromine-containing compound is at least one selected from the group consisting of hydrogen bromide, sodium bromide, potassium bromide and tetramethylammonium bromide.

4. A composition for etching according to any one of claims 1 to 3, wherein the oxidizing agent is hydrogen peroxide and/or nitric acid.

5. A composition for etching according to any one of claims 1 to 4, which includes, as the basic compound, at least one selected from the group consisting of tetramethylammonium hydroxide, potassium hydroxide and sodium hydroxide.

6. A composition for etching according to claim 1, wherein the pH is at least 10.5 and less than 12.

7. A composition for etching according to claim 2, wherein the pH is at least 10.5 and not higher than 13.

8. A composition for etching according to claim 1, wherein the ruthenium-based metal includes at least 70 atomic percent ruthenium.

9. A composition for etching according to claim 1, wherein the ruthenium-based metal is ruthenium metal.

10. A composition for etching according to claim 8, wherein the ruthenium-based metal includes at least 0.01 atomic percent and not greater than 30 atomic percent tantalum.

11. A composition for etching according to claim 2, wherein the ruthenium alloy includes at least 70 atomic percent and not greater than 99.99 atomic percent ruthenium.

12. A composition for etching according to claim 11, wherein the ruthenium alloy includes at least 0.01 atomic percent and not greater than 30 atomic percent tantalum.

13. A process for preparation of a composition for etching according to any one of claims 1 to 12, which has a step of using hydrobromic acid as the bromine-containing compound and an aqueous hydrogen peroxide solution and/or nitric acid as the oxidizing agent, and preparing a mixed aqueous solution to which at least the hydrogen bromide and oxidizing agent have been added, and a step of adding a basic compound to the mixed aqueous solution, so that the hydrogen bromide concentration is 2-25 mass% as bromine and the oxidizing agent concentration is 0.1-12 mass%, and so that pH is a prescribed value.

14. A method of treating a substrate, by etching of a ruthenium-based metal film and/or ruthenium alloy film accumulated on a substrate, using a composition for etching prepared by the process for preparation according to claim 13.
